# FASCICULE DE BREVET EUROPEEN

(11) **EP 2 693 242 B1**
(45) Date de publication et mention de la délivrance du brevet: **19.06.2019**
(21) Numéro de dépôt: 13178129.6
(22) Date de dépôt: 26.07.2013
(51) Int. Cl.: G02B 5/20, G02B 5/28, H01L 27/146, H01L 31/0232

(54) **Structure de filtrage optique dans le domaine visible et/ou infrarouge**
Optische Filterstruktur für sichtbaren und/oder infraroten Spektralbereich
Optical filter structure in the visible and/or infrared

(30) Priorité: 31.07.2012 FR 1257422
(43) Date de publication de la demande: 05.02.2014
(73) Titulaire: Commissariat à l'Énergie Atomique et aux Énergies Alternatives, 75015 Paris (FR)
(72) Inventeur: Frey, Laurent, 38600 FONTAINE (FR); Armand, Marilyn, 38100 GRENOBLE (FR); Pelle, Catherine, 38690 LONGECHENAL (FR)
(74) Mandataire: Ahner, Philippe

(56) Documents cités:
- EP-A1- 1 592 067
- WO-A1-2010/096914
- US-A- 5 140 457
- US-A1- 2008 251 873
- US-A1- 2009 225 204
- US-A1- 2009 321 865

## Description

### DOMAINE TECHNIQUE

L'invention concerne une structure de filtrage optique comportant deux filtres optiques voisins, l'un laissant passer une première bande spectrale et coupant une deuxième bande spectrale (par exemple de type passe-visible et coupe-infrarouge), et l'autre laissant passer la deuxième bande spectrale et coupant la première bande spectrale (par exemple de type passe-infrarouge et coupe-visible). Une telle structure de filtrage peut par exemple être utilisée dans un dispositif de type photodétecteur et/ou photoémetteur pour réaliser, sur un même support d'émission et/ou de réception lumineuse, à la fois un filtrage dans le domaine visible et un filtrage dans le domaine infrarouge, notamment proche infrarouge, ou encore des filtrages différents dans le domaine visible.

L'invention est avantageusement utilisée dans le domaine des composants photodétecteurs et/ou photoémetteurs présentant en particulier la fonction de détecter et/ou d'émettre de la lumière dans des bandes spectrales différentes selon la position sur le composant. Un tel composant peut correspondre à un capteur matriciel à base de silicium, de type CMOS ou CCD, avec ou sans système optique d'imagerie, apte à détecter de la lumière visible (c'est-à-dire les longueurs d'ondes comprises entre environ 400 nm et 700 nm), par exemple les couleurs vert et bleu sur un premier ensemble de pixels et la couleur rouge sur un deuxième ensemble de pixels, ou encore détecter la lumière visible sur un premier ensemble de pixels, et de la lumière proche infrarouge (tout ou partie du domaine 700 nm - 1100 nm) sur un deuxième ensemble de pixels.

L'invention s'applique notamment aux domaines des interfaces homme-machine, du contrôle de jeux vidéo ou de la télévision 3D, d'aide à la conduite automobile, de l'endoscopie, etc.

### ÉTAT DE LA TECHNIQUE ANTÉRIEURE

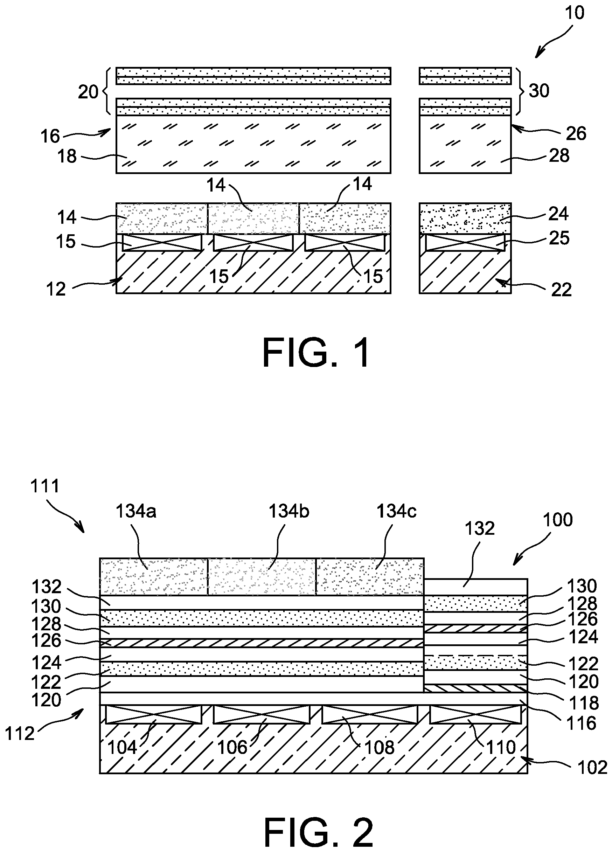

La figure 1 représente un dispositif photodétecteur 10 apte à réaliser une détection lumineuse à la fois dans le domaine visible et dans le domaine proche infrarouge. Le dispositif 10 utilise deux capteurs distincts, l'un pour les longueurs d'ondes du domaine visible et l'autre pour les longueurs d'ondes du domaine infrarouge.

Le dispositif 10 comporte un premier capteur CMOS 12 destiné à réaliser une détection dans le domaine visible. Des résines organiques colorées 14, formant par exemple une matrice de Bayer et permettant de réaliser un filtrage RVB (rouge, vert et bleu), sont disposées sur le premier capteur 12. Ces résines 14 sont directement intégrées sur le premier capteur 12, chacune étant associée à un pixel 15 du capteur 12. Les réponses spectrales des résines colorées 14 ne permettent pas, à elles seules, de reconstituer correctement les couleurs à cause de leur transmission non négligeable dans le domaine proche infrarouge. Un filtre supplémentaire 16 est donc généralement ajouté au-dessus des résines 14. Ce filtre supplémentaire 16 permet de couper les longueurs d'onde indésirables du domaine proche infrarouge, tout en transmettant efficacement les longueurs d'onde du domaine visible.

Ce filtre supplémentaire 16 comporte un substrat de verre 18 sur lequel sont réalisées de nombreuses couches diélectriques 20 (typiquement une trentaine) superposées les unes sur les autres et réalisées telles qu'elles assurent la fonction de filtre coupe-infrarouge et passe-visible.

Le dispositif 10 comporte un deuxième capteur CMOS 22 destiné à réaliser une détection dans le domaine infrarouge. Une résine noire 24 à faible transmission dans le domaine visible et à forte transmission dans le domaine infrarouge est disposée au-dessus des pixels 25 du deuxième capteur 22. Un filtre passe-infrarouge 26 est également ajouté au-dessus de la résine noire 24. Ce filtre 26 comporte un substrat de verre 28 sur lequel sont réalisées de nombreuses couches diélectriques 30 superposées les unes sur les autres et réalisées telles qu'elles assurent la fonction de filtre passe-infrarouge. Le filtre 26 laisse passer une partie des longueurs d'ondes du domaine visible, ces longueurs d'ondes étant toutefois filtrées par la résine noire 24.

Un tel dispositif 10 ne permet pas d'avoir des pixels prévus pour détecter le domaine visible et des pixels prévus pour détecter le domaine infrarouge qui soient entremêlés au sein d'un unique capteur, à moins d'intégrer les deux filtres multicouches diélectriques 16 et 26 directement sur les pixels (les substrats de verre 18 et 28 sont dans ce cas absents), ce qui représente une opération très complexe à réaliser compte tenu du nombre important de couches diélectriques 20 et 30 à déposer pour chacun des filtres 16 et 26, et des opérations de gravure longues et critiques compte tenu de l'épaisseur importante de diélectrique à graver (les couches diélectriques 20 et 30 devant être réalisées successivement).

Le document US 2009/321865 A1 décrit un dispositif imageur adapté pour détecter simultanément des longueurs d'ondes du domaine visible et infrarouge sur une même matrice de détection. Un filtre multicouches diélectriques de ce dispositif, dont les couches diélectriques sont communes aux parties visible et infrarouge du filtre, comporte une ou deux couches diélectriques d'épaisseur variable et assure ainsi un filtrage différencié des couleurs rouge, vert et bleu, ainsi que de l'infrarouge, en fonction de l'épaisseur de ces couches diélectriques.

Par rapport au dispositif représenté sur la figure 1, la solution proposée dans le document US 2009/321865 A1 permet la détection simultanément des longueurs d'ondes des domaines visible et infrarouge sur une même matrice de détection. Par contre, du fait que cette solution ne fait pas appel à un filtre coupe-infrarouge, la partie du filtre assurant le filtrage dans le domaine visible laisse passer une partie des longueurs d'ondes du domaine infrarouge. Il est donc nécessaire de soustraire le signal de mesure délivré par les pixels de la partie infrarouge aux signaux de mesure délivrés par les pixels de la partie du domaine visible afin d'obtenir des signaux de mesure RVB corrects. Bien qu'un tel dispositif ne nécessite pas de filtre coupe-infrarouge, l'opération de soustraction a l'inconvénient majeur de dégrader le rapport signal à bruit du dispositif. D'autre part, le nombre de couches diélectriques pour réaliser le filtrage est également important (18 couches de TiO₂ ou de SiO₂), ce qui implique un grand nombre d'étapes technologiques pour la réalisation de ce dispositif.

Le document US 5140457 divulgue un filtre comportant une couche métallique.

Les problèmes exposés ci-dessus se retrouvent également pour une structure de filtrage optique destinée à réaliser des filtrages de différentes bandes spectrales uniquement dans le domaine visible, ou encore de différentes bandes spectrales uniquement dans le domaine infrarouge.

### EXPOSÉ DE L'INVENTION

Un but de la présente invention est de proposer une structure de filtrage permettant de réaliser un premier filtrage apte à laisser passer une première bande spectrale et couper une deuxième bande spectrale, et un deuxième filtrage apte à laisser passer la deuxième bande spectrale et couper la première bande spectrale, qui soit adaptée pour fonctionner avec une unique matrice de détection et/ou d'émission dans les domaines visibles et/ou infrarouge, et faisant appel à un nombre moins important de couches diélectriques que les structures de filtrage de l'art antérieur.

Un autre but de la présente invention est de proposer une structure de filtrage permettant de réaliser, de manière juxtaposée, un premier filtrage passe-visible et coupe-infrarouge, et un deuxième filtrage passe-infrarouge et coupe-visible sans avoir à faire appel à une résine noire, qui soit adaptée pour fonctionner avec une unique matrice de détection et/ou d'émission dans les domaines visible et infrarouge, et qui fait appel à un nombre moins important de couches diélectriques que les structures de filtrage de l'art antérieur.

La présente invention propose une structure de filtrage optique définie dans la revendication 1.

La structure de filtrage selon l'invention forme donc des filtres juxtaposés dans des gammes de longueurs d'ondes différentes, par exemple dans le visible et l'infrarouge, formant par exemple des filtres RVB et IR, intégrables sur une même matrice de détection et/ou d'émission, dont la complexité de réalisation est limitée. Une telle structure de filtrage peut faire appel à des métaux tels que le cuivre ou l'aluminium couramment utilisés en micro-électronique.

L'utilisation d'un métal tel que le cuivre dont la partie réelle de l'indice de réfraction a des valeurs élevées (supérieures à 1) dans le domaine visible permet par ailleurs de réduire la sensibilité à l'angle d'incidence du premier filtre.

De façon inattendue pour l'homme de l'art (inattendue du fait que certains métaux tels que le cuivre présente une partie réelle de l'indice de réfraction qui varie fortement entre la gamme des longueurs d'ondes inférieures à environ 600 nm avec des valeurs élevées et la gamme des longueurs d'ondes supérieures à environ 600 nm, dont fait partie le domaine proche infrarouge, avec des valeurs inférieures à environ 0,5, et que l'épaisseur des couches diélectriques des filtres de l'art antérieur est directement corrélée à la longueur d'onde centrale d'un filtre), il est apparu qu'il est possible de concevoir et réaliser un premier filtre laissant passer une première gamme de longueurs d'ondes et coupant une deuxième gamme de longueurs d'ondes distincte de la première gamme, par exemple de type passe-visible et coupe-infrarouge, et un deuxième filtre laissant passer la deuxième gamme de longueurs d'ondes et coupant la première gamme de longueurs d'ondes, par exemple de type passe-infrarouge et coupe visible, avec un empilement de couches diélectriques au sein duquel est disposée au moins une couche métallique pour réaliser le deuxième filtre et comportant peu de couches (par exemple moins de 10) d'épaisseur variable entre les deux filtres et/ou présentes uniquement dans le deuxième filtre, les autres couches diélectriques comportant une même épaisseur dans les deux filtres, et présentant des réponses spectrales utilisables pour de nombreuses applications. Dans la structure de filtrage de l'invention, les épaisseurs des couches diélectriques ne sont pas choisies telles qu'elles soient directement proportionnelles aux longueurs d'ondes destinées à être filtrées par les filtres de la structure de filtrage.

L'alternance de couches diélectriques d'indices de réfraction différents (par exemple environ 2 pour des couches de SiN, et 1,45 pour des couches de SiO₂) permet la réalisation du premier et du deuxième filtres tels qu'ils présentent des réponses spectrales différentes mais comprenant une bonne transmission des longueurs d'ondes souhaitées (celles du domaine visible pour le premier filtre et celles du domaine infrarouge pour le deuxième filtre) et une bonne réjection des autres longueurs d'ondes.

En permettant une détection et/ou une émission de plusieurs bandes spectrales sur une même matrice de détection et/ou d'émission, un dispositif photodétecteur et/ou photoémetteur faisant appel à une telle structure de filtrage peut synchroniser des informations (telles que des images) issues des différents canaux (réponses spectrales), ce qui réduit la complexité et le coût de réalisation d'un tel dispositif par rapport à un dispositif faisant appel à plusieurs matrices distinctes de détection et/ou d'émission. L'invention permet de réaliser plusieurs filtres spectraux différents aptes à être intégrés sur une même matrice de détection et/ou d'émission. De plus, la structure de filtrage selon l'invention peut être réalisée via un procédé relativement simple et à partir de matériaux utilisés classiquement dans les fonderies micro-électroniques, contrairement aux structures de filtrages de l'art antérieur réalisées uniquement à partir de matériaux diélectriques (qui doivent être déposés sur des substrats externes et imposent l'utilisation de plusieurs matrices de détection, et/ou faisant appel à une nombre important de couches diélectriques, et notamment un nombre important de couches non communes entre les deux filtres) ou nécessitant la présence de métaux contaminant tels que l'argent.

La structure de filtrage selon l'invention peut par exemple être réalisée avec moins de 10 couches diélectriques, ou moins de 15 couches diélectriques. Le nombre de couches de l'empilement de la structure de filtrage selon l'invention dépend notamment de la sélectivité des réponses spectrales souhaitées, c'est-à-dire des tolérances en ce qui concerne la transmission et de la réjection des filtres de la structure.

Bien que la ou les couches métalliques de la structure de filtrage selon l'invention soient de préférence à base de cuivre ou d'aluminium, cette ou ces couches peuvent toutefois être à base d'un métal contaminant tel que l'argent. Dans ce cas, la structure de filtrage selon l'invention présente une meilleure transmission par rapport aux filtres Ag/diélectrique de l'art antérieur de par l'utilisation de deux matériaux diélectriques d'indices de réfraction différents.

La présence d'une ou plusieurs couches métalliques supplémentaires dans le deuxième filtre par rapport au premier filtre permet d'éviter d'avoir à utiliser, lorsque la structure de filtrage est destinée à réaliser des filtrages distincts d'une part dans le domaine visible et d'autre part dans le domaine infrarouge, une résine noire qui est coûteuse et complexe à mettre en oeuvre. La présence, dans le premier filtre, d'un nombre de couches métalliques inférieur à celui dans le deuxième filtre permet de minimiser l'absorption de la lumière visible par le métal, pénalisante en particulier pour le bleu et le vert, tandis que la présence d'un plus grand nombre de couches métalliques dans le deuxième filtre permet d'améliorer la réjection de ce filtre dans le domaine visible.

La structure de filtrage selon l'invention peut avantageusement être utilisée dans le domaine de l'imagerie passive multispectrale (par exemple visible et infrarouge, ou RVB et infrarouge pour réaliser une photodétection de jour comme de nuit), de l'imagerie active de profondeur (photodétection 3D) et de couleur avec illumination dans le proche infrarouge (projection de franges ou temps de vol), ou encore de la détection multispectrale sans imagerie (par exemple pour réaliser une mesure de caractéristiques spectrales d'un illuminant).

Il est possible de considérer qu'un filtre réalise une transmission des longueurs d'onde d'une première bande spectrale et qu'il coupe les longueurs d'onde d'une deuxième bande spectrale lorsque le rapport de la transmission moyenne dans la première bande spectrale sur la transmission moyenne dans la deuxième bande spectrale est supérieur à 2 ou 3, et de préférence supérieur à environ 10, 50 ou 100.

Une couche est qualifiée de « commune » à plusieurs filtres, ou continue dans ces filtre, lorsqu'au moins une partie de cette couche se prolonge dans tous les filtres, c'est-à-dire lorsque cette partie de cette couche est présente dans tous les filtres pour lesquels cette couche est qualifiée de « commune ». Ainsi, une couche commune à deux filtres, ou plusieurs filtres, peut avoir des épaisseurs différentes dans ces filtres lorsque cette couche a, dans un premier filtre, une épaisseur initiale, et qu'une partie seulement de cette épaisseur initiale se retrouve dans un deuxième filtre.

Les longueurs d'ondes de la première bande spectrale peuvent être inférieures à environ 600 nm et les longueurs d'ondes de la deuxième bande spectrale peuvent être supérieures à environ 600 nm.

Les premières et deuxièmes couches métalliques peuvent être à base de cuivre et/ou d'aluminium, et/ou les couches diélectriques peuvent être à base de SiN (par exemple sous sa forme stoechiométrique Si₃N₄ ou non stoechiométrique Si_{X}N_{Y}) et/ou de SiO₂ et/ou de TiO₂ et/ou de Ta₂O₅ et/ou de HfO₂ et/ou de ZrO₂ et/ou de ZnS et/ou de ZnSe et/ou de MgF₂ et/ou de SiOCH et/ou de Na₃AlF₆.

L'empilement de couches peut comporter une ou plusieurs couches de SiO₂ chacune disposée entre deux couches de SiN.

Chaque couche métallique peut être disposée entre deux couches diélectriques à base d'un même matériau diélectrique. Dans ce cas, chaque couche métallique peut être à base de cuivre ou d'aluminium et disposée entre deux couches de SiN.

Au moins une desdites couches diélectriques peut comporter, dans le premier filtre, une épaisseur inférieure, ou supérieure, à son épaisseur dans le deuxième filtre.

Dans le premier filtre, au moins une couche diélectrique peut comporter plusieurs portions d'épaisseurs différentes telles que le premier filtre comporte plusieurs parties présentant des réponses spectrales différentes.

En variante, la structure de filtrage peut comporter en outre une matrice de filtres colorés disposée sur le premier filtre.

Les parties du premier filtre présentant les réponses spectrales différentes ou la matrice de filtres colorés disposée sur le premier filtre peut former une matrice de filtrage de trois couleurs rouge, vert et bleu, par exemple sous la forme d'une matrice de Bayer.

La première bande spectrale peut correspondre au domaine visible et la deuxième bande spectrale peut correspondre à au moins une partie du domaine infrarouge.

Les longueurs d'ondes de la première bande spectrale peuvent correspondre aux couleurs vert et bleu, et les longueurs d'ondes de la deuxième bande spectrale peuvent correspondre à la couleur rouge.

L'invention concerne également un dispositif photodétecteur et/ou photoémetteur comportant au moins :
- une matrice de pixels apte à réaliser une photodétection et/ou une photoémission dans la gamme des longueurs d'ondes du domaine visible et/ou du domaine infrarouge ;
- une structure de filtrage selon l'invention disposée en regard de la matrice de pixels telle que le premier filtre soit disposé en regard d'un premier ensemble de pixels de la matrice et que le deuxième filtre soit disposé en regard d'un deuxième ensemble de pixels de la matrice.

La structure de filtrage peut être disposée à proximité ou sur la matrice de pixels.

L'invention concerne également un procédé de réalisation d'une structure de filtrage optique défini par la revendication 13.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente un dispositif photodétecteur de l'art antérieur fonctionnant dans les domaines visible et infrarouge ;
- la figure 2 représente partiellement et schématiquement un dispositif photodétecteur, objet de la présente invention, comportant une structure de filtrage, également objet de la présente invention, selon un premier mode de réalisation ;
- la figure 3 représente les réponses spectrales des filtres de la structure de filtrage, objet de la présente invention, selon le premier mode de réalisation ;
- la figure 4 représente partiellement et schématiquement un dispositif photodétecteur, objet de la présente invention, comportant une structure de filtrage, également objet de la présente invention, selon un deuxième mode de réalisation ;
- la figure 5 représente les réponses spectrales des filtres de la structure de filtrage, objet de la présente invention, selon le deuxième mode de réalisation ;
- les figures 6 et 7 représentent les réponses spectrales des filtres de la structure de filtrage, objet de la présente invention, selon différentes variantes du premier mode de réalisation ;
- la figure 8 représente les réponses spectrales des filtres de la structure de filtrage, objet de la présente invention, selon une variante de réalisation.

Des parties identiques, similaires ou équivalentes des différentes figures décrites ci-après portent les mêmes références numériques de façon à faciliter le passage d'une figure à l'autre.

Les différentes parties (notamment les couches) représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

On se réfère à la figure 2 qui représente partiellement et schématiquement un dispositif photodétecteur 100 apte à réaliser une détection lumineuse dans le domaine visible et dans le domaine infrarouge, selon un premier mode de réalisation.

Le dispositif 100 comporte un capteur 102, par exemple de type CCD ou CMOS, comprenant une matrice de pixels. Un premier ensemble de pixels du capteur 102 est destiné à réaliser une photodétection dans le domaine visible, et un deuxième ensemble de pixels du capteur 102 est destiné à réaliser une photodétection dans le domaine infrarouge. Sur l'exemple de la figure 2, quatre pixels 104 à 110 sont représentés. Les trois pixels 104, 106 et 108 sont destinés à réaliser une photodétection dans le domaine visible (le pixel 104 pour le bleu, le pixel 106 pour le vert et le pixel 108 pour le rouge), tandis que le pixel 110 est destiné à réaliser une photodétection dans le domaine infrarouge.

Les deux ensembles de pixels peuvent éventuellement être entremêlés, par exemple sous la forme d'une matrice de Bayer intégrant un filtrage RVB et IR. Dans une telle matrice, pour chaque groupe de 4 pixels disposés les uns à côté des autres en carré, 3 pixels sont destinés à détecter chacun l'une des couleurs rouge, verte et bleu, et le quatrième pixel est destiné à détecter l'infrarouge.

Le capteur 102 est recouvert par une structure de filtrage 111 destinée à filtrer la lumière reçue par le dispositif photodétecteur 100. Les pixels du premier ensemble qui sont destinés à réaliser une photodétection dans le domaine visible (correspondant aux pixels 104, 106 et 108 sur l'exemple de la figure 2) sont recouverts par un premier filtre passe-visible et coupe-infrarouge 112, c'est-à-dire dont la réponse spectrale laisse passer les longueurs d'ondes du domaine visible et coupe les longueurs d'ondes du domaine infrarouge. Les pixels du deuxième ensemble destinés à réaliser une photodétection dans le domaine infrarouge (correspondant au pixel 110 sur l'exemple de la figure 2) sont recouverts par une deuxième filtre passe-infrarouge et coupe-visible 114, c'est-à-dire dont la réponse spectrale laisse passer les longueurs d'ondes du domaine infrarouge et coupe les longueurs d'ondes du domaine visible. Ces deux filtres 112, 114 sont obtenus à partir d'un empilement de couches réalisé de manière commune pour les deux filtres 112, 114. Dans ces deux filtres 112, 114, la transmission et la réjection spectrale est obtenue du fait de la disposition alternée de couches diélectriques d'indices de réfraction différents (ici des couches de SiN d'indice de réfraction égal à environ 2, et des couches de SiO₂ d'indice de réfraction égal à environ 1,45), ainsi que de la présence d'une couche métallique supplémentaire dans le deuxième filtre 114 par rapport au premier filtre 112. Les couches diélectriques présentant un indice de réfraction élevé peuvent être par exemple être composées de SiN (par exemple sous sa forme stoechiométrique Si₃N₄ ou non stoechiométrique Si_{X}N_{Y}) et/ou de TiO₂ et/ou de Ta₂O₅ et/ou de HfO₂ et/ou de ZrO₂ et/ou de ZnS et/ou de ZnSe. Les couches diélectriques présentant un indice de réfraction faible peuvent être par exemple composées de SiO₂ et/ou de MgF₂ et/ou de SiOCH et/ou de Na₃AlF₆. Les matériaux des couches diélectriques alternées (alternance indice de réfraction fort / indice de réfraction faible) présentant des indices de réfraction différents peuvent être choisis tels qu'ils présentent une différence d'indice de réfraction supérieure à environ 0,3, et de préférence supérieure à environ 0,5.

La ou les couches métalliques de la structure de filtrage 111 peuvent être composées de cuivre (qui permet notamment de réaliser un bon filtrage pour la bande spectrale de la couleur rouge et l'infrarouge), et/ou d'aluminium et/ou d'argent et/ou d'or.

Lors de la conception des filtres 112, 114, les épaisseurs des différentes couches des filtres sont évaluées dans un premier temps de façon approximative via un algorithme de calcul de filtres multicouches optimisant les empilements des filtres considérés individuellement, par rapport à des gabarits spectraux souhaités. Ces valeurs sont ensuite utilisées comme données d'entrée dans un code qui met en oeuvre une technique numérique d'optimisation globale pour ajuster plus finement les épaisseurs des différentes couches des filtres 112, 114 considérés simultanément. Des contraintes d'égalité sont fixées entre certaines épaisseurs de couches des filtres, pour imposer une épaisseur constante entre les deux filtres. Les filtres 112, 114 sont donc conçus en essayant d'obtenir un maximum de couches communes de même épaisseur d'un filtre à l'autre.

Chaque filtre peut tout d'abord être conçu individuellement à l'aide d'un logiciel de calcul optique multicouches, tel que par exemple le logiciel Optilayer, qui utilise la théorie matricielle d'Abélès pour calculer la réponse optique d'un empilement de couches minces, et une méthode d'optimisation de type « needles » (comme décrit par dans le document de A.V. Tikhonravov, M.K. Trubetskov, and G.W. DeBell, "Application of the needle optimization technique to the design of optical coatings", Applied Optics, 1996, 35, Vol. 28, pp. 5493-5508) pour fournir un empilement de réponses spectrales s'approchant au mieux du gabarit souhaité. Les filtres sont ensuite considérés simultanément en partant des solutions individuelles fournies par le précédent logiciel de calcul.

L'optimisation permettant de considérer les couches des filtres comme communes entre eux peut faire appel à des techniques d'optimisation sous contrainte de type recuit simulé.

La différence entre les réponses spectrales des deux filtres 112, 114 provient de la variation de l'épaisseur d'au moins une des couches diélectriques entre les deux filtres (ici une couche de SiO₂ dont l'épaisseur dans le deuxième filtre 114 est supérieure à son épaisseur dans le premier filtre 112), ainsi que de la présence d'une couche métallique supplémentaire dans le deuxième filtre passe-infrarouge et coupe-visible 114 par rapport au premier filtre coupe-infrarouge et passe-visible 112.

On décrit maintenant la réalisation des différentes couches de l'empilement de la structure de filtrage 111 selon le premier mode de réalisation de la figure 2.

Les filtres 112 et 114 sont réalisés en déposant tout d'abord, par exemple par PECVD, une première couche de SiN 116 dont l'épaisseur est égale à environ 85 nm. Une première couche métallique 118, par exemple composée de cuivre et dont l'épaisseur est égale à environ 38 nm, est ensuite déposée sur la première couche de SiN 116. Cette première couche de cuivre 118 est photolithographiée et gravée afin de ne conserver cette première couche de cuivre 118 qu'au niveau du deuxième filtre 114, c'est-à-dire en regard des pixels destinés à réaliser une photodétection dans le domaine infrarouge (c'est-à-dire le pixel 110 sur l'exemple de la figure 2). La résine utilisée pour réaliser cette photolithographie est ensuite éliminée.

On réalise ensuite le dépôt d'une deuxième couche de SiN 120 dont l'épaisseur est par exemple égale à environ 15 nm. Du fait de la présence de la première couche de cuivre 118 uniquement dans le deuxième filtre 114, la partie de la deuxième couche de SiN 120 dans le premier filtre 112 n'est pas disposée sur un même plan que celle dans le deuxième filtre 114.

On souhaite ensuite réaliser, sur la deuxième couche de SiN 120, une première couche de SiO₂ 122 comprenant, au niveau du premier filtre 112, une épaisseur égale à environ 84 nm, et au niveau du deuxième filtre 114, une épaisseur égale à environ 191 nm. Pour cela, on réalise tout d'abord un premier dépôt, sur la deuxième couche de SiN 120, de SiO₂ d'épaisseur égale à environ 107 nm (191 nm - 84 nm = 107 nm). Ce dépôt de SiO₂ est photo-lithographié et gravé afin de ne conserver du SiO₂ qu'au niveau du deuxième filtre 114, c'est-à-dire en regard des pixels destinés à réaliser une photo-détection dans le domaine infrarouge (pixel 110 sur l'exemple de la figure 2). La résine utilisée pour réaliser cette photolithographie est ensuite éliminée. La première couche de SiO₂ 122 est ensuite achevée en réalisant un deuxième dépôt de SiO₂ d'épaisseur égale à environ 84 nm. Ce deuxième dépôt de SiO₂ recouvre, au niveau du premier filtre 112, la deuxième couche de SiN 120, et au niveau du filtre 114, le premier dépôt de SiO₂.

Les filtres 112 et 114 de la structure de filtrage 111 sont ensuite achevés par les dépôts des couches suivantes qui sont communes et qui comportent une même épaisseur dans les deux filtres 112, 114 :
- une troisième couche de SiN 124 d'épaisseur égale à environ 27 nm ;
- une deuxième couche métallique 126, ici composée de cuivre et d'épaisseur égale à environ 23 nm ;
- une quatrième couche de SiN 128 d'épaisseur égale à environ 62 nm ;
- une deuxième couche de SiO₂ 130 d'épaisseur égale à environ 15 nm ;
- une cinquième couche de SiN 132 d'épaisseur égale à environ 62 nm.

Le tableau ci-dessous résume les épaisseurs des couches diélectriques et métalliques utilisées pour réaliser les deux filtres 112 et 114 de la structure de filtrage 111. L'ordre des couches indiquées dans ce tableau correspond à l'ordre d'empilement, de bas en haut du tableau, des couches dans la structure de filtrage 111.

| | 1er filtre 112 | 2ème filtre 114 |
|---|---|---|
| Couche 132 SiN | 62 nm | |
| Couche 130 SiO2 | 15 nm | |
| Couche 128 SiN | 62 nm | |
| Couche 126 Cu | 23 nm | |
| Couche 124 SiN | 27 nm | |
| Couche 122 SiO2 | 84 nm | 191 nm |
| Couche 120 SiN | 15 nm | |
| Couche 118 Cu | 0 | 38 nm |
| Couche 116 SiN | 85 nm | |

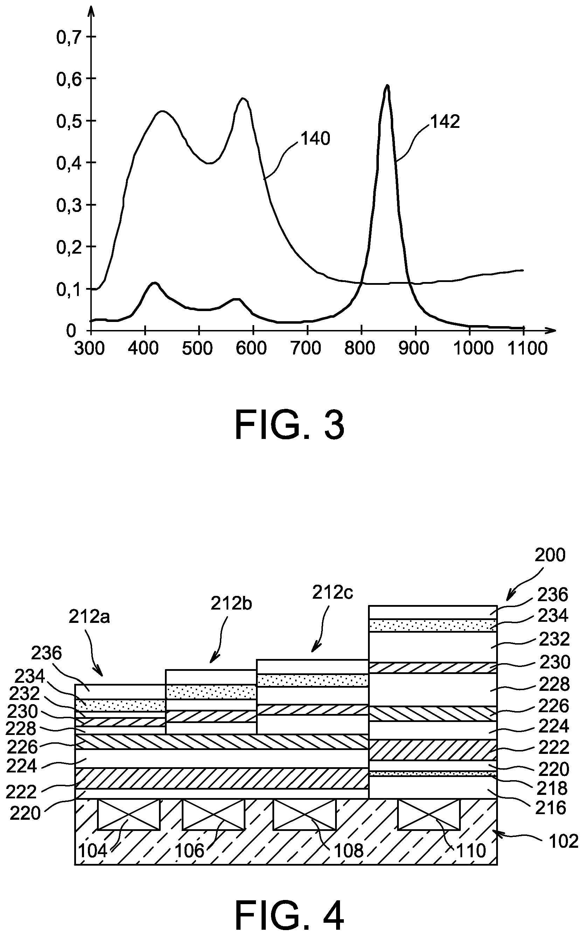

Les réponses spectrales (valeur du coefficient de transmission en fonction de la longueur d'onde en nm) des filtres 112 et 114, respectivement référencées 140 et 142, sont représentées sur la figure 3.

La valeur « 0 » indiquée pour la couche 118 de cuivre au niveau du premier filtre 112 indique que cette couche est absente au niveau du premier filtre 112 et qu'elle n'est donc présente que dans le deuxième filtre 114. Le deuxième filtre 114, qui est passe-infrarouge et coupe-visible, comporte donc une couche métallique supplémentaire (première couche de cuivre 118) par rapport au premier filtre 112 qui est passe-visible et coupe-infrarouge. La présence d'une seule couche de cuivre dans l'empilement de couches formant le premier filtre 112 permet de minimiser l'absorption de la lumière visible par le métal, pénalisante en particulier dans le bleu et le vert, tandis que la présence de deux couches de cuivre dans l'empilement du filtre passe-infrarouge 114 permet d'améliorer la réjection de ce filtre dans le domaine visible.

La variation d'épaisseur de la première couche de SiO₂ 122 entre les deux filtres 112 et 114 permet d'améliorer la transmission et la réjection de certaines bandes spectrales de façon plus spécifique pour chacun des deux filtres 112, 114. Les autres couches sont communes aux deux filtres 112, 114 et ont des épaisseurs similaires dans les deux filtres 112, 114. La différence entre les réponses spectrales des deux filtres 112, 114 est due à :
- la présence d'une couche métallique supplémentaire (couche 118) dans le deuxième filtre 114 par rapport au premier filtre 112 ;
- la variation d'épaisseur d'une seule couche diélectrique (couche 122) entre les deux filtres 112 et 114, toutes les autres couches étant communes et similaires dans les deux filtres 112, 114.

Dans cet exemple, la transmission maximale des deux filtres 112, 114, de l'ordre de 50 %, et la réjection en dehors de la résonance, sont suffisantes pour de nombreuses applications envisagées. Les réponses spectrales des filtres 112, 114 pourraient être optimisées si un nombre plus important de couches était envisagé pour réaliser ces filtres.

Afin de réaliser une détection des composantes rouge, vert et bleu du spectre visible, des filtres colorés 134 sont réalisés sur la cinquième couche de SiN 132, en regards des pixels du capteur 102 destinés à réaliser une photo-détection dans le domaine visible, c'est-à-dire sur le premier filtre 112, en regard des pixels du premier ensemble de pixels. Ces filtres colorés 134 sont par exemple réalisés à partir de résines colorés. Sur l'exemple de la figure 2, un filtre coloré 134a de couleur bleu est disposé en regard du pixel 104, un filtre coloré 134b de couleur verte est disposé en regard du pixel 106 et un filtre coloré 134c de couleur rouge est disposé en regard du pixel 108. L'étalement et le contrôle de l'épaisseur des résines sur les couches des filtres 112 et 114 est possible dès lors que le relief (différence d'épaisseur totale entre les filtres 112 et 114) est inférieur à l'épaisseur des résines à déposer. Dans l'exemple précédemment décrit, la différence d'épaisseur entre les deux filtres 112, 114 n'est que d'environ 145 nm, ce qui est inférieur à l'épaisseur des résines organiques colorées utilisées pour réaliser les filtres colorés 134 (comprise entre environ 800 à 1000 nm).

Pour réaliser les filtres colorés 134, une première résine colorée (par exemple rouge) est tout d'abord étalée par spin-coating sur la cinquième couche de SiN 132, au niveau des deux filtres 112 et 114. La résine étalée est ensuite durcie par recuit, puis photo-lithographiée et enfin développée pour définir les motifs prévus pour les filtres colorés rouges (c'est-à-dire localisée au-dessus des pixels destinés à réaliser une photodétection dans la bande spectrale de la couleur rouge, correspondant au pixel 108 sur la figure 2). Ces opérations sont ensuite répétées avec des résines des deux autres couleurs.

Dans l'exemple précédemment décrit, le dispositif 100 est un dispositif photodétecteur. En variante, le dispositif 100 pourrait être un dispositif photoémetteur. Dans ce cas, par rapport au dispositif 100 décrit, le capteur 102 serait remplacé par un substrat comportant des moyens émissifs lumineux (émettant dans les bandes spectrales visibles et infrarouge) sur lesquels les filtres 112 et 114 seraient disposés, ainsi qu'éventuellement les filtres colorés 134 si l'on souhaite réaliser, dans le domaine visible, des émissions dans des bandes spectrales restreintes à des couleurs précises. Il serait également possible d'avoir un dispositif photodétecteur et photoémetteur, les moyens émissifs lumineux étant dans ce cas combinés aux photodétecteurs sous les filtres 112 et 114.

Le tableau suivant donne les épaisseurs de couches diélectriques et métalliques utilisées pour réaliser les deux filtres 112 et 114 selon une première variante de la structure de filtrage 111 du premier mode de réalisation. Comme pour le tableau précédent, l'ordre des couches indiquées dans ce tableau correspond à l'ordre d'empilement, de bas en haut du tableau, des couches dans la structure de filtrage selon cette première variante de réalisation.

| | 1er filtre 112 | 2ème filtre 114 |
|---|---|---|
| Couche SiN | 108 nm | |
| Couche SiO2 | 144 nm | |
| Couche SiN | 105 nm | |
| Couche SiO2 | 157 nm | |
| Couche SiN | 0 | 82 nm |
| Couche Cu | 0 | 38 nm |
| Couche SiN | 90 nm | |
| Couche SiO2 | 143 nm | |
| Couche SiN | 106 nm | |
| Couche SiO2 | 144 nm | |
| Couche SiN | 107 nm | |

Les valeurs « 0 » indiquées pour la couche de cuivre et l'une des couches de SiN au niveau du premier filtre 112 indiquent que ces couche sont absentes au niveau de premier filtre 112 et qu'elles sont présentes uniquement dans le deuxième filtre 114.

Comme précédemment, la structure de filtrage selon cette première variante de réalisation comporte des couches diélectriques d'indices de réfraction différents disposées de manière alternée (alternance des indices de réfraction forts et faibles). Par contre, dans cette première variante de réalisation, le deuxième filtre 114 passe-infrarouge et coupe-visible comporte une seule couche métallique, ici composée de cuivre, et le premier filtre 112 passe-visible et coupe-infrarouge ne comporte aucune couche métallique et est uniquement composé d'une alternance de couches diélectriques d'indices de réfraction différents. De plus, dans cette première variante de réalisation, une des couches diélectriques n'est présente que dans le deuxième filtre 114.

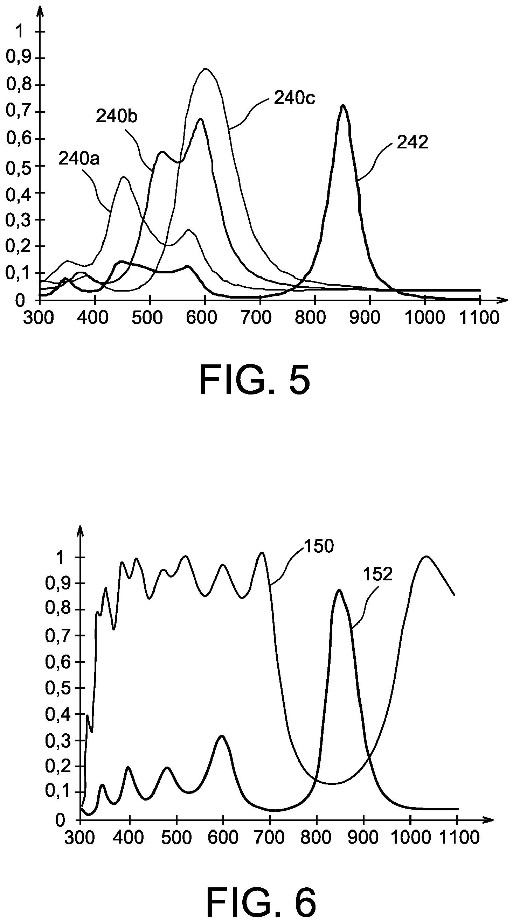

Les réponses spectrales (valeur du coefficient de transmission en fonction de la longueur d'onde en nm) des filtres 112 et 114 de la structure de filtrage selon cette première variante de réalisation, respectivement référencées 150 et 152, sont représentées sur la figure 6.

Le tableau suivant donne les épaisseurs de couches diélectriques et métalliques utilisées pour réaliser les deux filtres 112 et 114 selon une deuxième variante de la structure de filtrage 111 du premier mode de réalisation. Comme pour le tableau précédent, l'ordre des couches indiquées dans ce tableau correspond à l'ordre d'empilement, de bas en haut du tableau, des couches de la structure de filtrage selon cette deuxième variante de réalisation.

| | 1er filtre 112 | 2ème filtre 114 |
|---|---|---|
| Couche SiN | 108 nm | |
| Couche SiO2 | 148 nm | |
| Couche SiN | 108 nm | |
| Couche Cu | 0 | 15 nm |
| Couche SiN | 0 | 175 nm |
| Couche Cu | 0 | 37 nm |
| Couche SiN | 0 | 85 nm |
| Couche SiO2 | 148 nm | |
| Couche SiN | 108 nm | |
| Couche SiO2 | 148 nm | |
| Couche SiN | 108 nm | |
| Couche SiO2 | 148 nm | |
| Couche SiN | 109 nm | |

Les valeurs « 0 » indiquées pour les couches de cuivre et deux des couches de SiN au niveau du premier filtre 112 indiquent que ces couche sont absentes au niveau de premier filtre 112 et qu'elles ne sont donc présentes que dans le deuxième filtre 114.

Comme précédemment, la structure de filtrage selon cette deuxième variante de réalisation comporte des couches diélectriques d'indices de réfraction différents disposées de manière alternée les unes par rapport aux autres. Dans cette deuxième variante de réalisation, le deuxième filtre 114 passe-infrarouge et coupe-visible comporte deux couches métalliques, ici composées de cuivre, et le premier filtre 112 passe-visible et coupe-infrarouge ne comporte aucune couche métallique et est uniquement composé d'une alternance de couches diélectriques d'indices de réfraction différents. De plus, toutes les couches qui sont communes aux deux filtres 112 et 114 ont une épaisseur constante d'un filtre à l'autre. Deux couches diélectriques composées de SiN sont présentes uniquement dans le deuxième filtre 114.

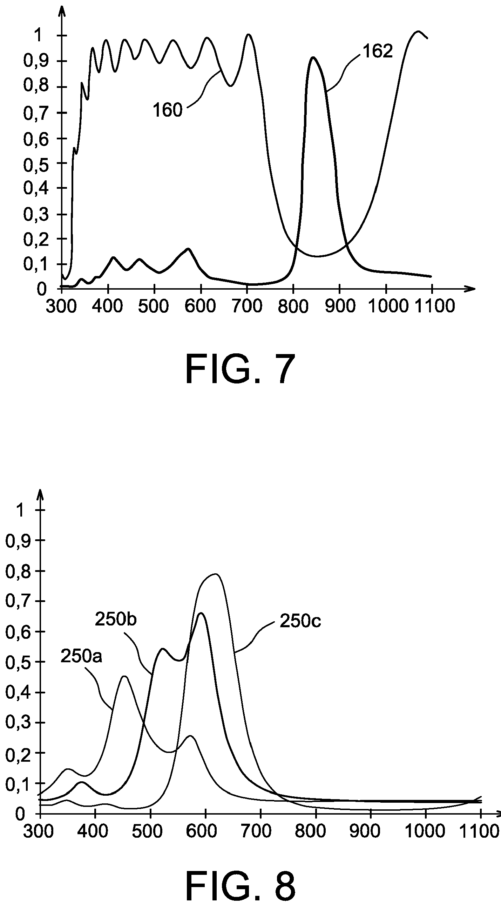

Les réponses spectrales (valeur du coefficient de transmission en fonction de la longueur d'onde en nm) des filtres 112 et 114 de la structure de filtrage selon cette deuxième variante de réalisation, respectivement référencées 160 et 162, sont représentées sur la figure 7.

Sur les figures 6 et 7, on voit que les réponses spectrales 150 et 160 des filtres passe-visible et coupe-infrarouge des structures de filtrage présentent une remontée de leur coefficient de transmission dans le domaine infrarouge, au-delà d'environ 950 nm. Toutefois, une telle remontée n'est pas gênante lorsqu'une telle structure de filtrage est couplée à un capteur et/ou un émetteur composé de silicium qui est peu sensible à ces longueurs d'ondes.

On se réfère maintenant à la figure 4 qui représente partiellement et schématiquement un dispositif photodétecteur 200 apte à réaliser une détection lumineuse dans les domaines visible et infrarouge, selon un deuxième mode de réalisation.

Comme le dispositif 100 précédemment décrit, le dispositif 200 comporte le capteur 102 précédemment décrit. Le capteur 102 est recouvert par une structure de filtrage 211 qui comporte un premier filtre 212 de type passe-visible et coupe infrarouge, et un deuxième filtre 214 de type passe-infrarouge et coupe-visible. Comme pour les filtres 112, 114 précédemment décrits, les filtres 212 et 214 sont réalisés à partir d'un empilement de couches dont la plupart sont communes aux deux filtres. De plus, comme pour les filtres 112, 114, la transmission et la réjection spectrale réalisées par les filtres 212 et 214 sont obtenues du fait de l'utilisation de couches diélectriques d'indices de réfraction différents (couches de SiN et couches de SiO₂ dans l'exemple décrit ici), ainsi que de la présence d'une couche métallique supplémentaire dans le deuxième filtre 214 par rapport au premier filtre 212.

Toutefois, contrairement à la structure de filtrage 111 qui fait appel à des résines colorées pour réaliser, au sein du spectre visible, le filtrage des couleurs rouge, vert et bleu, le premier filtre 212 comporte des couches qui ont des épaisseurs variables au sein même du premier filtre 212 afin de réaliser les différents filtrages souhaités dans le domaine visible, par exemple une fonction de filtrage RVB. Ainsi, le premier filtre 212 comporte une première partie 212a disposée en regard des pixels destinés à capturer la bande spectrale correspondant à la couleur bleu (pixel 104 sur l'exemple de la figure 4) et formant un filtre laissant passer uniquement cette bande spectrale. De même, des parties 212b et 212c disposées en regard des pixels destinés à capturer respectivement les bandes spectrales correspondant aux couleurs verte et rouge (pixels 106 et 108 sur l'exemple de la figure 4) forment des filtres laissant passer uniquement ces bandes spectrales.

Le tableau ci-dessous donne les épaisseurs des couches diélectriques et métalliques utilisées pour réaliser les deux filtres 212, 214.

| | 1er filtre 212 | | | 2ème filtre 214 |
|---|---|---|---|---|
| | 212a | 212b | 212c | |
| SiN 236 | 66 nm | | | |
| SiO2 234 | 69 nm | | | |
| SiN 232 | 36 nm | 55 nm | 71 nm | 156 nm |
| Cu 230 | 34 nm | | | |
| SiN 228 | 27 nm | 50 nm | 69 nm | 139 nm |
| SiO2 226 | 68 nm | | | |
| SiN 224 | 86 nm | | | |
| SiO2 222 | 95 nm | | | |
| SiN 220 | 31 nm | | | |
| Cu 218 | 0 | | | 16 nm |
| SiN 216 | 0 | | | 102 nm |

Les réponses spectrales des parties 212a, 212b, 212c du premier filtre 212, respectivement référencées 240a, 240b et 240c, et la réponse spectral du deuxième filtre 214, portant la référence 242, sont représentées sur la figure 5.

Les différences entre les deux filtres 212 et 214 sont :
- la présence d'une seule couche de Cu dans l'empilement de couches du premier filtre 212, et de deux couches de Cu dans l'empilement du deuxième filtre 214 ;
- la variation d'épaisseur de deux couches diélectriques (composées de SiN dans cet exemple) entre les deux filtres 212 et 214 ;
- la présence d'une couche diélectrique (ici à base de SiN) supplémentaire dans le deuxième filtre 214 par rapport au premier filtre 212.

De plus, au sein du premier filtre 212, le filtrage des différentes bandes spectrales RVB est obtenu du fait que les deux couches diélectriques d'épaisseurs différentes entre les deux filtres 212 et 214 présentent également des épaisseurs différentes au sein des différentes parties 212a, 212b et 212c du premier filtre 212.

Toutes les autres couches de l'empilement de la structure de filtrage 211 sont communes et d'épaisseur constante dans les deux filtres 212 et 214.

Comme pour la structure de filtrage 111, l'empilement de couches de la structure de filtrage 211 permet de réaliser le deuxième filtre 214 qui coupe les longueurs d'ondes du domaine visible sans faire appel à une résine noire.

Comme pour le dispositif 100, le dispositif 200 pourrait être un dispositif photoémetteur, ou bien un dispositif photodétecteur et photoémetteur.

En variante, les dispositifs 100 et 200 pourraient être aptes à réaliser une détection lumineuse et/ou une émission lumineuse uniquement dans le domaine visible, ou dans le domaine infrarouge. Dans ce cas, la présence d'une couche métallique supplémentaire dans le deuxième filtre pourrait être mise à profit pour que le premier filtre soit apte à réaliser un filtrage d'une bande spectrale correspondant aux couleurs bleu et vert, et que le deuxième filtre, qui comporte la couche métallique supplémentaire, soit apte à réaliser un filtrage d'une bande spectrale correspondant à la couleur rouge. Le tableau ci-dessous correspond à un exemple de réalisation d'une structure de filtrage d'un dispositif apte à réaliser une détection lumineuse et/ou une émission lumineuse uniquement dans le domaine visible. Dans cette structure, le premier filtre comporte une première partie apte à réaliser un filtrage d'une bande spectrale correspondant à la couleur bleu et une deuxième partie apte à réaliser un filtrage d'une bande spectrale correspondant à la couleur vert, et le deuxième filtre, qui comporte une couche métallique supplémentaire, est apte à réaliser un filtrage d'une bande spectrale correspondant à la couleur rouge.

| | 1er filtre | | 2ème filtre |
|---|---|---|---|
| | 1ère partie | 2ème partie | |
| SiN | 66 nm | | |
| SiO2 | 69 nm | | |
| SiN | 36 nm | 55 nm | 71 nm |
| Cu | 34 nm | | |
| SiN | 27 nm | 50 nm | 69 nm |
| SiO2 | 68 nm | | |
| SiN | 0 | | 130 nm |
| Cu | 0 | | 16 nm |
| SiN | 86 nm | | |
| SiO2 | 95 nm | | |
| SiN | 31 nm | | |

La couche de cuivre supplémentaire se trouvant dans le 2^{ème} filtre et non dans le 1^{er} filtre permet en outre d'améliorer la sélectivité, et notamment la réjection, du 2^{ème} filtre.

Les réponses spectrales de la 1^{ère} partie du premier filtre, de la deuxième partie du premier filtre, et du deuxième filtre, respectivement référencées 250a, 250b et 250c, sont représentées sur la figure 8.

Dans tous les modes et exemples de réalisation précédemment décrits, lorsque la ou les couches métalliques sont à base de cuivre, on utilise alors judicieusement la chute brutale de la valeur de l'indice de réfraction du cuivre autour des longueurs d'ondes comprises entre environ 550 nm et 600 nm.

Les empilements de couches des modes et exemples de réalisation précédemment décrits peuvent être formés sur un substrat de SiO₂, et la couche supérieure de ces empilements peut être en contact avec un superstrat d'air.

## Revendications

1. Structure de filtrage optique (111, 211) comportant un empilement de couches formant au moins un premier filtre (112, 212) apte à laisser passer les longueurs d'ondes d'une première bande spectrale et couper les longueurs d'ondes d'une deuxième bande spectrale, et un deuxième filtre (114, 214) voisin du premier filtre (112, 212) et apte à laisser passer les longueurs d'ondes de la deuxième bande spectrale et couper les longueurs d'ondes de la première bande spectrale, dans laquelle l'empilement de couches comporte :
- une pluralité de couches diélectriques (116, 120 - 124, 128 - 132, 220 - 228, 232 - 236) communes au premier filtre (112, 212) et au deuxième filtre (114, 214) et formant une alternance de couches d'indices de réfraction différents ;
- n premières couches métalliques (126, 230) communes au premier filtre (112, 212) et au deuxième filtre (114, 214) ;
- m deuxièmes couches métalliques (118, 218) disposées uniquement dans le deuxième filtre (114, 214) ;
et dans laquelle :
- au moins une desdites couches diélectriques (122, 228, 232) comporte, dans le premier filtre (112, 212), une épaisseur différente de celle dans le deuxième filtre (114, 214), et/ou au moins une couche diélectrique (216) est disposée uniquement dans le premier (112, 212) ou le deuxième filtre (114, 214) ; et
- les autres couches diélectriques (116, 120, 124, 128 - 132, 220 - 226, 234 - 236) ont une même épaisseur dans les premier et deuxième filtres (112, 114, 212, 214) ;
n étant un nombre entier supérieur ou égal à 0, et m étant un nombre entier supérieur ou égal à 1.

2. Structure de filtrage (111, 211) selon la revendication 1, dans lequel les longueurs d'ondes de la première bande spectrale sont inférieures à environ 600 nm et les longueurs d'ondes de la deuxième bande spectrale sont supérieures à environ 600 nm.

3. Structure de filtrage (111, 211) selon l'une des revendications précédentes, dans laquelle les premières (126, 230) et deuxièmes couches métalliques (118, 218) sont à base de cuivre et/ou d'aluminium, et/ou dans lequel les couches diélectriques (116, 120 - 124, 128 - 132, 220 - 228, 232 - 236) sont à base de SiN et/ou de SiO₂ et/ou de TiO₂ et/ou de Ta₂O₅ et/ou de HfO₂ et/ou de ZrO₂ et/ou de ZnS et/ou de ZnSe et/ou de MgF₂ et/ou de SiOCH et/ou de Na₃AlF₆.

4. Structure de filtrage (111, 211) selon l'une des revendications précédentes, dans laquelle l'empilement de couches comporte une ou plusieurs couches de SiO₂ (122, 130, 222, 226, 234) chacune disposée entre deux couches de SiN (120, 124, 128, 132, 220, 224, 228, 232, 236).

5. Structure de filtrage (111, 211) selon l'une des revendications précédentes, dans laquelle chaque couche métallique (118, 126, 218, 230) est disposée entre deux couches diélectriques (116, 120, 124, 128, 216, 220, 228, 232) à base d'un même matériau diélectrique.

6. Structure de filtrage (111, 211) selon la revendication 5, dans laquelle chaque couche métallique (118, 126, 218, 230) est à base de cuivre ou d'aluminium et disposée entre deux couches de SiN (116, 120, 124, 128, 216, 220, 228, 232).

7. Structure de filtrage (211) selon l'une des revendications précédentes, dans laquelle, dans le premier filtre (212), au moins une couche diélectrique (228, 232) comporte plusieurs portions d'épaisseurs différentes telles que le premier filtre (212) comporte plusieurs parties (212a, 212b, 212c) présentant des réponses spectrales différentes.

8. Structure de filtrage (111) selon l'une des revendications 1 à 6, comportant en outre une matrice de filtres colorés (134a, 134b, 134c) disposée sur le premier filtre (112).

9. Structure de filtrage (111, 211) selon l'une des revendications 7 ou 8, dans laquelle les parties (212a, 212b, 212c) du premier filtre (212) présentant les réponses spectrales différentes ou la matrice de filtres colorés (134a, 134b, 134c) disposée sur le premier filtre (112) forme une matrice de filtrage de trois couleurs rouge, vert et bleu.

10. Structure de filtrage (111, 211) selon l'une des revendications précédentes, dans lequel la première bande spectrale correspond au domaine visible et la deuxième bande spectrale correspond à au moins une partie du domaine infrarouge.

11. Structure de filtrage (111, 211) selon l'une des revendications 7 ou 8, dans lequel les longueurs d'ondes de la première bande spectrale correspondent aux couleurs vert et bleu, et les longueurs d'ondes de la deuxième bande spectrale correspondent à la couleur rouge.

12. Dispositif (100, 200) photodétecteur et/ou photoémetteur comportant au moins :
- une matrice de pixels (104 - 110) apte à réaliser une photodétection et/ou une photoémission dans la gamme des longueurs d'ondes du domaine visible et/ou du domaine infrarouge ;
- une structure de filtrage (111, 211) selon l'une des revendications précédentes disposée en regard de la matrice de pixels (104 - 110) telle que le premier filtre (112, 212) soit disposé en regard d'un premier ensemble de pixels (104 - 108) de la matrice et que le deuxième filtre (114, 214) soit disposé en regard d'un deuxième ensemble de pixels (110) de la matrice.

13. Procédé de réalisation d'une structure de filtrage optique (111, 211) comportant la mise en oeuvre d'étapes de dépôt, photolithographie et gravure de matériaux diélectriques et métalliques, réalisant un empilement de couches formant au moins un premier filtre (112, 212) apte à laisser passer les longueurs d'ondes d'une première bande spectrale et couper les longueurs d'ondes d'une deuxième bande spectrale, et un deuxième filtre (114, 214) voisin du premier filtre (112, 212) et apte à laisser passer les longueurs d'ondes de la deuxième bande spectrale et couper les longueurs d'ondes de la première bande spectrale, et dans laquelle l'empilement de couches comporte :
- une pluralité de couches diélectriques (116, 120 - 124, 128 - 132, 220
- 228, 232 - 236) communes au premier filtre (112, 212) et au deuxième filtre (114, 214) et formant une alternance de couches d'indices de réfraction différents ;
- n premières couches métalliques (126, 230) communes au premier filtre (112, 212) et au deuxième filtre (114, 214) ;
- m deuxièmes couches métalliques (118, 218) disposées uniquement dans le deuxième filtre (114, 214) ;
et dans laquelle :
- au moins une desdites couches diélectriques (122, 228, 232) comporte, dans le premier filtre (112, 212), une épaisseur différente de celle dans le deuxième filtre (114, 214), et/ou au moins une couche diélectrique (216) est disposée uniquement dans le premier (112, 212) ou le deuxième filtre (114, 214) ; et
- les autres couches diélectriques (116, 120, 124, 128 - 132, 220 - 226, 234 - 236) ont une même épaisseur dans les premier et deuxième filtres (112, 114, 212, 214) ;
n étant un nombre entier supérieur ou égal à 0, et m étant un nombre entier supérieur ou égal à 1.

## Patentansprüche

1. Optische Filterstruktur (111, 211), umfassend einen Stapel von Schichten, die mindestens einen ersten Filter (112, 212) bilden, der geeignet ist, die Wellenlängen eines ersten Spektralbereichs hindurchzulassen und die Wellenlängen eines zweiten Spektralbereichs abzuschneiden, und einen zweiten Filter (114, 214), der dem ersten Filter (112, 212) benachbart und geeignet ist, die Wellenlängen des zweiten Spektralbereichs hindurchzulassen und die Wellenlängen des ersten Spektralbereichs abzuschneiden, wobei der Stapel von Schichten umfasst:
- eine Vielzahl dielektrischer Schichten (116, 120 - 124, 128 - 132, 220 - 228, 232 - 236), die der erste Filter (112, 212) und der zweite Filter (114, 214) gemeinsam haben und abwechselnd Schichten mit unterschiedlichen Brechungsindices bilden;
- n erste Metallschichten (126, 230), die der erste Filter (112, 212) und der zweite Filter (114, 214) gemeinsam haben;
- m zweite Metallschichten (118, 218), die nur in dem zweiten Filter (114, 214) angeordnet sind;
und wobei:
- mindestens eine der dielektrischen Schichten (122, 228, 232), in dem ersten Filter (112, 212), eine andere Dicke als jene in dem zweiten Filter (114, 214) umfasst, und/oder mindestens eine dielektrische Schicht (216) nur in dem ersten (112, 212) oder dem zweiten Filter (114, 214) angeordnet ist; und
- die anderen dielektrischer Schichten (116, 120, 124, 128 - 132, 220 - 226, 234 - 236) dieselbe Dicke in dem ersten und zweiten Filter (112, 114, 212, 214) aufweisen;
wobei n eine ganze Zahl größer oder gleich 0 ist, und m eine ganze Zahl größer oder gleich 1 ist.

2. Filterstruktur (111, 211) nach Anspruch 1,
wobei die Wellenlängen des ersten Spektralbereichs kleiner sind als ungefähr 600 nm und die Wellenlängen des zweiten Spektralbereichs größer sind als ungefähr 600 nm.

3. Filterstruktur (111, 211) nach einem der vorhergehenden Ansprüche,
wobei die ersten (126, 230) und die zweiten Metallschichten (118, 218) auf der Basis von Kupfer und/oder Aluminium sind, und/oder wobei die dielektrischen Schichten (116, 120 - 124, 128 - 132, 220 - 228, 232 - 236) auf der Basis von SiN und/oder von SiO₂ und/oder von TiO₂ und/oder von Ta₂O₅ und/oder von HfO₂ und/oder von ZrO₂ und/oder von ZnS und/oder von ZnSe und/oder von MgF₂ und/oder von SiOCH und/oder von Na₃AlF₆ sind.

4. Filterstruktur (111, 211) nach einem der vorhergehenden Ansprüche,
wobei der Stapel von Schichten eine oder mehrere Schichten aus SiO₂ (122, 130, 222, 226, 234) umfasst, wobei jede zwischen zwei Schichten aus SiN (120, 124, 128, 132, 220, 224, 228, 232, 236) angeordnet ist.

5. Filterstruktur (111, 211) nach einem der vorhergehenden Ansprüche,
wobei jede Metallschicht (118, 126, 218, 230) zwischen zwei dielektrischen Schichten (116, 120, 124, 128, 216, 220, 228, 232) auf der Basis desselben dielektrischen Materials angeordnet ist.

6. Filterstruktur (111, 211) nach Anspruch 5,
wobei jede Metallschicht (118, 126, 218, 230) auf der Basis von Kupfer oder von Aluminium ist und zwischen zwei Schichten aus SiN (116, 120, 124, 128, 216, 220, 228, 232) angeordnet ist.

7. Filterstruktur (211) nach einem der vorhergehenden Ansprüche,
wobei in dem ersten Filter (212) mindestens eine dielektrische Schicht (228, 232) mehrere Abschnitte mit unterschiedlicher Dicke umfasst, so dass der erste Filter (212) mehrere Teile (212a, 212b, 212c) umfasst, die unterschiedliche Spektralempfindlichkeiten aufweisen.

8. Filterstruktur (111) nach einem der Ansprüche 1 bis 6, außerdem umfassend eine Matrix von Farbfiltern (134a, 134b, 134c), die auf dem ersten Filter (112) angeordnet ist.

9. Filterstruktur (111, 211) nach einem der Ansprüche 7 oder 8,
wobei die Teile (212a, 212b, 212c) des ersten Filters (212) die unterschiedlichen Spektralempfindlichkeiten aufweisen, oder die auf dem ersten Filter (112) angeordnete Matrix von Farbfiltern (134a, 134b, 134c) eine Filtermatrix der drei Farben rot, grün und blau bildet.

10. Filterstruktur (111, 211) nach einem der vorhergehenden Ansprüche,
wobei der erste Spektralbereich dem sichtbaren Bereich entspricht, und der zweite Spektralbereich mindestens einem Teil des Infrarotbereichs entspricht.

11. Filterstruktur (111, 211) nach einem der Ansprüche 7 oder 8,
wobei die Wellenlängen des ersten Spektralbereichs den Farben grün und blau entsprechen, und die Wellenlängen des zweiten Spektralbereichs der Farbe Rot entsprechen.

12. Fotodetektor- und/oder Fotoemitter-Vorrichtung (100, 200), mindestens umfassend:
- eine Pixelmatrix (104 - 110), die geeignet ist, eine Fotodetektion und/oder eine Fotoemission im Wellenlängenbereich des sichtbaren Bereichs und/oder des Infrarotbereichs durchzuführen;
- eine Filterstruktur (111, 211) nach einem der vorhergehenden Ansprüche, die gegenüber der Pixelmatrix (104 - 110) angeordnet ist, so dass der erste Filter (112, 212) gegenüber einer ersten Gesamtheit von Pixeln (104 - 108) der Matrix angeordnet ist, und so dass der zweite Filter (114, 214) gegenüber einer zweiten Gesamtheit von Pixeln (110) der Matrix angeordnet ist.

13. Verfahren zur Herstellung einer optischen Filterstruktur (111, 211), umfassend die Durchführung der Schritte der Abscheidung, Fotolithografie und Gravur dielektrischer und metallischer Materialien, wobei ein Stapel von Schichten hergestellt wird, die mindestens einen ersten Filter (112, 212) bilden, der geeignet ist, die Wellenlängen eines ersten Spektralbereichs hindurchzulassen und die Wellenlängen eines zweiten Spektralbereichs abzuschneiden, und einen zweiten Filter (114, 214), der dem ersten Filter (112, 212) benachbart und geeignet ist, die Wellenlängen des zweiten Spektralbereichs hindurchzulassen und die Wellenlängen des ersten Spektralbereichs abzuschneiden, und wobei der Stapel von Schichten umfasst:
- eine Vielzahl dielektrischer Schichten (116, 120 - 124, 128 - 132, 220 - 228, 232 - 236), die der erste Filter (112, 212) und der zweite Filter (114, 214) gemeinsam haben und abwechselnd Schichten mit verschiedenen Brechungsindices bilden;
- n erste Metallschichten (126, 230), die der erste Filter (112, 212) und der zweite Filter (114, 214) gemeinsam haben;
- m zweite Metallschichten (118, 218), die nur in dem zweiten Filter (114, 214) angeordnet sind;
und wobei:
- mindestens eine der dielektrischen Schichten (122, 228, 232), in dem ersten Filter (112, 212), eine andere Dicke als jene in dem zweiten Filter (114, 214) umfasst, und/oder mindestens eine dielektrische Schicht (216) nur in dem ersten (112, 212) oder dem zweiten Filter (114, 214) angeordnet ist; und
- die anderen dielektrischer Schichten (116, 120, 124, 128 - 132, 220 - 226, 234 - 236) dieselbe Dicke in dem ersten und zweiten Filter (112, 114, 212, 214) aufweisen;
wobei n eine ganze Zahl größer oder gleich 0 ist, und m eine ganze Zahl größer oder gleich 1 ist.

## Claims

1. An optical filtering structure (111, 211) comprising a stack of layers forming at least one first filter (112, 212) able to let pass the wavelengths of a first spectral band and cut off the wavelengths of a second spectral band, and a second filter (114, 214) adjacent to the first filter (112, 212) and able to let pass the wavelengths of the second spectral band and cut off the wavelengths of the first spectral band, wherein the stack of layers comprises:
- a plurality of dielectric layers (116, 120 - 124, 128 - 132, 220 - 228, 232 - 236) common to the first filter (112, 212) and to the second filter (114, 214) and forming an alternation of layers of different refractive indices;
- n first metal layers (126, 230) common to the first filter (112, 212) and to the second filter (114, 214);
- m second metal layers (118, 218) arranged only in the second filter (114, 214);
and wherein:
- at least one of said dielectric layers (122, 228, 232) comprises, in the first filter (112, 212), a thickness different to that in the second filter (114, 214), and/or at least one dielectric layer (216) is arranged only in the first (112, 212) or the second filter (114, 214); and
- the other dielectric layers (116, 120, 124, 128 - 132, 220 - 226, 234 - 236) have the same thickness in the first and second filters (112, 114, 212, 214);
n being an integer greater than or equal to 0, and m being an integer greater than or equal to 1.

2. The filtering structure (111, 211) according to claim 1, wherein the wavelengths of the first spectral band are less than around 600 nm and the wavelengths of the second spectral band are greater than around 600 nm.

3. The filtering structure (111, 211) according to one of previous claims, wherein the first (126, 230) and second metal layers (118, 218) comprise copper and/or aluminium, and/or wherein the dielectric layers (116, 120 - 124, 128 - 132, 220 - 228, 232 - 236) comprise SiN and/or SiO₂ and/or TiO₂ and/or Ta₂O₅ and/or HfO₂ and/or ZrO₂ and/or ZnS and/or ZnSe and/or MgF₂ and/or SiOCH and/or Na₃AlF₆.

4. The filtering structure (111, 211) according to one of previous claims, wherein the stack of layers comprises one or more layers of SiO₂ (122, 130, 222, 226, 234) each arranged between two layers of SiN (120, 124, 128, 132, 220, 224, 228, 232, 236).

5. The filtering structure (111, 211) according to one of previous claims, wherein each metal layer (118, 126, 218, 230) is arranged between two dielectric layers (116, 120, 124, 128, 216, 220, 228, 232) comprising a same dielectric material.

6. The filtering structure (111, 211) according to claim 5, wherein each metal layer (118, 126, 218, 230) comprises copper or aluminium and is arranged between two layers of SiN (116, 120, 124, 128, 216, 220, 228, 232).

7. The filtering structure (211) according to one of previous claims, wherein, in the first filter (212), at least one dielectric layer (228, 232) comprises several portions of different thicknesses such that the first filter (212) comprises several parts (212a, 212b, 212c) having different spectral responses.

8. The filtering structure (111) according to one of claims 1 to 6, further comprising an array of coloured filters (134a, 134b, 134c) arranged on the first filter (112).

9. The filtering structure (111, 211) according to one of claims 7 or 8, wherein the parts (212a, 212b, 212c) of the first filter (212) having the different spectral responses or the array of coloured filters (134a, 134b, 134c) arranged on the first filter (112) form a filtering array of three colours red, green and blue.

10. The filtering structure (111, 211) according to one of previous claims, wherein the first spectral band corresponds to the visible domain and the second spectral band corresponds to at least one part of the infrared domain.

11. The filtering structure (111, 211) according to one of claims 7 or 8, wherein the wavelengths of the first spectral band correspond to the colours green and blue, and the wavelengths of the second spectral band correspond to the colour red.

12. A photodetector and/or photoemitter device (100, 200) comprising at least:
- one array of pixels (104 - 110) able to carry out a photodetection and/or a photoemission in the range of wavelengths of the visible domain and/or the infrared domain;
- one filtering structure (111, 211) according to one of previous claims arranged facing the array of pixels (104 - 110) such that the first filter (112, 212) is arranged facing a first set of pixels (104 - 108) of the array and that the second filter (114, 214) is arranged opposite a second set of pixels (110) of the array.

13. A method for making an optical filtering structure (111, 211) comprising the implementation of steps of depositing, photolithography and etching of dielectric and metal materials, forming a stack of layers forming at least one first filter (112, 212) able to let pass the wavelengths of a first spectral band and cut off the wavelengths of a second spectral band, and a second filter (114, 214) adjacent to the first filter (112, 212) and able to let pass the wavelengths of the second spectral band and cut off the wavelengths of the first spectral band, and wherein the stack of layers comprises:
- a plurality of dielectric layers (116, 120 - 124, 128 - 132, 220 - 228, 232 - 236) common to the first filter (112, 212) and to the second filter (114, 214) and forming an alternation of layers of different refractive indices;
- n first metal layers (126, 230) common to the first filter (112, 212) and to the second filter (114, 214);
- m second metal layers (118, 218) arranged only in the second filter (114, 214);
and wherein:
- at least one of said dielectric layers (122, 228, 232) comprises, in the first filter (112, 212), a thickness different to that in the second filter (114, 214), and/or at least one dielectric layer (216) is arranged only in the first (112, 212) or the second filter (114, 214); and
- the other dielectric layers (116, 120, 124, 128 - 132, 220 - 226, 234 - 236) have the same thickness in the first and second filters (112, 114, 212, 214);
n being an integer greater than or equal to 0, and m being an integer greater than or equal to 1.
